(19) Europäisches Patentamt / European Patent Office / Office européen des brevets

(11) **EP 4 753 417 A1**

(12) **DEMANDE DE BREVET EUROPEEN**

(43) Date de publication:
**03.06.2026 Bulletin 2026/23**

(21) Numéro de dépôt: **25217588.0**

(22) Date de dépôt: **21.11.2025**

(51) Classification Internationale des Brevets (IPC):
**H10K 30/85** (2023.01)   **H10K 30/40** (2023.01)
**H10K 71/30** (2023.01)   **H10K 85/50** (2023.01)
**H10K 30/57** (2023.01)   **H10K 71/12** (2023.01)

(52) Classification Coopérative des Brevets (CPC):
**H10K 85/50; H10K 30/40; H10K 30/85;**
**H10K 71/30;** H10K 30/57; H10K 71/12

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **27.11.2024 GR 20240100845**
**27.12.2024 FR 2415313**

(71) Demandeur: **Commissariat à l'Energie Atomique et aux Energies Alternatives**
**75015 Paris (FR)**

(72) Inventeurs:
• **TSOULKA, Polyxeni**
**38054 GRENOBLE CEDEX 09 (FR)**
• **BERSON, Solenn**
**38054 GRENOBLE CEDEX 09 (FR)**

(74) Mandataire: **Cabinet Beaumont**
**4, Place Robert Schuman**
**B.P. 1529**
**38025 Grenoble Cedex 1 (FR)**

(54) **PROCEDE DE FABRICATION D'UN DISPOSITIF OPTOELECTRONIQUE**

(57) La présente description concerne un dispositif optoélectronique (100) comprenant une couche active en pérovskite (140), la couche active en pérovskite (140) étant dopée au samarium, depuis une première face, sur une partie (141) de son épaisseur, une couche tampon (150), par exemple en BPC ou en oxyde, étant en contact direct avec la partie dopée (141) de la couche active en pérovskite (140),

la pérovskite ayant pour formule $ABX_3$ avec A représentant un ou plusieurs cations, de préférence choisis parmi le méthylammonium, le formamidinium et le césium,

B représentant du plomb, de l'étain ou un de leurs mélanges, X représentant un ou plusieurs anions, de préférence choisis parmi le chlore, le brome, l'iode et leurs mélanges.

Le dopage peut être réalisé en déposant sur la première face de la couche active en pérovskite (140) une solution contenant du samarium, de préférence par dépôt à la tournette en mode dynamique.

Fig. 2A

Fig. 8

**Description**

Domaine technique

La présente description concerne de façon générale le domaine des dispositifs optoélectroniques, et plus particulièrement, des dispositifs optoélectroniques comprenant une couche en pérovskite, notamment les cellules photovoltaïques simple jonction ou les cellules photovoltaïques tandem silicium/pérovskite.

Technique antérieure

Il existe plusieurs types de cellules photovoltaïques à base de pérovskite.

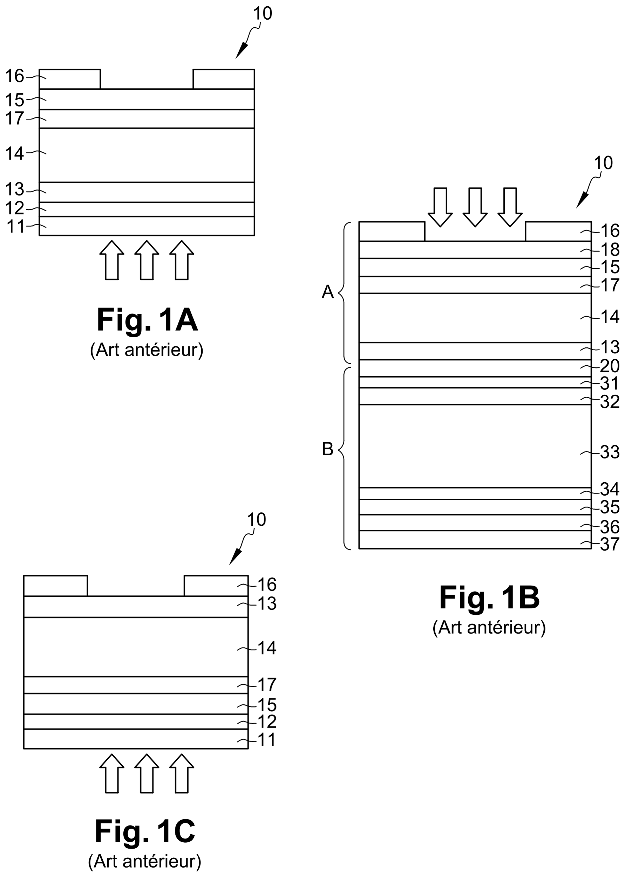

Par exemple, la figure 1A représente une cellule photovoltaïque 10 simple jonction de type p-i-n comprenant depuis la face soumise au rayonnement lumineux : un substrat 11, une couche d'oxyde transparent conducteur 12, une couche de transport de trous 13, une couche active en pérovskite 14, une couche de transport d'électron 17, une couche tampon 15 et des électrodes 16.

Par exemple, la figure 1B représente une cellule photovoltaïque tandem comprenant une sous-cellule à base de pérovskite 10 et une sous-cellule à base de silicium. La cellule comprend depuis la face soumise au rayonnement lumineux : des électrodes 16, une couche d'oxyde transparent conducteur 12, une couche tampon 15, une couche de transport d'électron 17, une couche active en pérovskite 14, une couche de transport de trous 13, une couche intermédiaire entre les deux sous-cellules en oxyde transparent conducteur 20, une couche en silicium amorphe dopé n 31, une couche à base de silicium amorphe intrinsèque 32 servant de couche en passivation, un substrat en silicium cristallin dopé n 33, une couche à base de silicium amorphe intrinsèque 34 servant de couche en passivation, une couche en silicium amorphe dopé p 35, une électrode 36, de préférence transparente.

Par exemple, la figure 1C représente une cellule photovoltaïque 10 simple jonction de type n-i-p comprenant depuis la face soumise au rayonnement lumineux : un substrat 11, une couche d'oxyde transparent conducteur 12, une couche tampon 15, une couche de transport d'électron 17, une couche active en pérovskite 14, une couche de transport de trous 13, et des électrodes 16.

Ces cellules comprennent une couche en transport des électrons (ETL pour 'Electron Transport Layer') située entre la couche en pérovskite et une électrode. La couche ETL permet de séparer les électrons générés par la couche en pérovksite, de les extraire et de les transporter vers l'électrode.

La couche ETL est souvent formée d'un bicouche comprenant une couche d'extraction de type n et une couche tampon de type n. La couche tampon permet d'augmenter les performances de la cellule, en limitant les recombinaisons de charges aux interfaces entre la pérovskite et l'électrode supérieure augmentent.

La couche tampon peut être en BCP, LiF, ou en oxyde métallique transparent, par exemple en $SnO_2$.

La couche de type n est, par exemple, à base de fullerène (C60). Le C60 est un semiconducteur de type n très répandu dans le domaine du photovoltaïque.

Cependant, l'utilisation de C60 crée des problèmes de stabilité de la cellule (à la lumière et en température) et de recombinaisons de charges au niveau de l'interface pérovskite/C60, ce qui diminue le rendement photovoltaïque.

Résumé de l'invention

Il existe un besoin d'avoir un procédé de fabrication d'un dispositif optoélectronique performant et simple à fabriquer.

Ce but est atteint par un dispositif optoélectronique comprenant une couche active en pérovskite, la couche active en pérovskite étant dopée au samarium, depuis une première face de la couche active en pérovskite, sur une partie de son épaisseur, une couche tampon, par exemple en BPC ou en oxyde, étant en contact direct avec la première face de la couche active en pérovskite,

la pérovskite ayant pour formule $ABX_3$ avec A représentant un cation organique ou inorganique ou une combinaison d'un ou plusieurs cations organiques et/ou d'un ou plusieurs cations inorganiques, de préférence choisis parmi le méthylammonium, le formamidinium et le césium,
B représentant du plomb, de l'étain ou un de leurs mélanges,
X représentant un ou plusieurs anions, en particulier un ou plusieurs halogènes, de préférence choisis parmi le chlore, le brome, l'iode et un de leurs mélanges.

Selon un mode de réalisation particulier, la pérovskite a pour formule $(Cs,FA)(Sn,Pb)(I,Br)_3$, de préférence $(Cs,FA)Pb(I,Br)_3$.

Selon un mode de réalisation particulier, la partie dopée de la couche active en pérovskite a une épaisseur comprise entre 50 et 150 nm, de préférence entre 80 et 120 nm.

Selon un mode de réalisation particulier, le dispositif optoélectronique est une cellule photovoltaïque à simple jonction de type p-i-n, comprenant, par exemple, depuis une face soumise à un rayonnement lumineux :

- un substrat,
- une électrode inférieure,
- une couche conductrice de type p,
- la couche active en pérovskite dopée au samarium, depuis la première face de la couche active en pérovskite, sur une partie de son épaisseur,
- une couche tampon en contact direct avec la première face de la couche active en pérovskite,
- une électrode supérieure.

Selon un mode de réalisation particulier, le dispositif optoélectronique est une cellule photovoltaïque tandem pérovskite sur silicium de type p-i-n comprenant deux sous-cellules empilées l'une sur l'autre, une première sous-cellule étant une sous-cellule en pérovskite et une deuxième sous-cellule étant une sous-cellule en silicium, par exemple une sous-cellule à hétérojonction de silicium, la première sous-cellule comprenant, par exemple, depuis une face soumise à un rayonnement lumineux :

- une électrode supérieure,
- une couche d'oxyde transparent conducteur,
- une couche tampon en contact direct avec la première face de la couche active en pérovskite,
- la couche active en pérovskite dopée au samarium, depuis la première face de la couche active en pérovskite, sur une partie de son épaisseur,
- une couche conductrice de type p.

Selon un mode de réalisation particulier, le dispositif optoélectronique est une cellule photovoltaïque à simple jonction de type n-i-p, comprenant, par exemple, depuis une face soumise à un rayonnement lumineux :

- un substrat,
- une électrode inférieure,
- une couche tampon en contact direct avec la première face de la couche active en pérovskite,
- la couche active en pérovskite dopée au samarium, depuis la première face de la couche active en pérovskite, sur une partie de son épaisseur,
- une couche conductrice de type p,
- une électrode supérieure.

Ce but est également atteint par un procédé de fabrication d'un dispositif optoélectronique comprenant une étape au cours de laquelle une couche active en pérovskite est dopée au samarium depuis une première face de la couche active, sur une partie de son épaisseur, moyennant quoi une couche de type n est formée dans la couche active en pérovskite,

la pérovskite ayant pour formule $ABX_3$ avec A représentant un cation organique ou inorganique ou une combinaison d'un ou plusieurs cations organiques et/ou d'un ou plusieurs cations inorganiques, de préférence choisis parmi le méthylammonium, le formamidinium et le césium,
B représentant du plomb, de l'étain ou un de leurs mélanges,
X représentant un ou plusieurs anions, en particulier un ou plusieurs halogènes, de préférence choisis parmi le chlore, le brome, l'iode et un de leurs mélanges,
une couche tampon, par exemple en BPC ou en oxyde, étant en contact direct avec la première face de la couche active en pérovskite.

Selon un mode de réalisation particulier, le dopage au samarium est obtenu en déposant une solution contenant du samarium, par exemple $SmI_2$ ou $Sm(acac)_3$, sur la couche active en pérovskite.

Selon un mode de réalisation particulier, la solution comprend du $SmI_2$ et de l'isopropanol.

Selon un mode de réalisation particulier, la solution est déposée par dépôt à la tournette en mode dynamique selon les sous-étapes suivantes :

- mettre en rotation la structure contenant la couche active en pérovskite dans une machine de dépôt à la tournette, par exemple à 3000 tours/min,

- déposer la solution contenant du samarium, sur la couche active en pérovskite, la structure étant toujours en rotation,
- maintenir la rotation après le dépôt de la solution, par exemple pendant une durée de 30s,
- arrêter la rotation de la structure.

Selon un mode de réalisation particulier, la solution a une concentration en $SmI_2$ inférieure ou égale à 2mg/mL, de préférence comprise entre 0,5mg/mL et 2mg/mL.

Selon un mode de réalisation particulier, le dispositif optoélectronique est une cellule photovoltaïque de type p-i-n, par exemple une cellule photovoltaïque tandem silicium sur pérovskite ou une cellule photovoltaïque à simple jonction.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1A, la figure 1B et la figure 1C, précédemment décrites, représentent, de manière schématique et en coupe, respectivement, une cellule photovoltaïque pérovskite simple jonction p-i-n, une cellule photovoltaïque tandem silicium/pérovskite p-i-n et une cellule photovoltaïque pérovskite simple jonction n-i-p, selon l'art antérieur ;

la figure 2A, la figure 2B et la figure 2C représentent, de manière schématique et en coupe, respectivement, une cellule photovoltaïque pérovskite simple jonction p-i-n, une cellule photovoltaïque tandem silicium/pérovskite p-i-n et une cellule photovoltaïque pérovskite simple jonction n-i-p, selon différents modes de réalisation particuliers de l'invention ;

la figure 3 représente plusieurs clichés A), B) et C) obtenus au microscope électronique à balayage (MEB), respectivement, d'une part, de la surface d'une couche de pérovskite donnée à titre de référence (B.1), et d'autre part, de la surface d'une couche de pérovskite ayant reçu un traitement de surface avec une composition de $SmI_2$ à 2mg/mL (B.2) et de la surface d'une couche de pérovskite ayant reçu un traitement de surface avec une composition de $SmI_2$ à 10mg/mL (B.3) selon différents modes de réalisation particuliers de l'invention ;

la figure 4 représente plusieurs clichés A), B) et C) correspondant à des vues en coupe des échantillons observés à la figure 3 ;

la figure 5A représente l'analyse UV-visible des échantillons observés aux figures 3 et 4 ;

la figure 5B représente le traitement de données pour obtenir l'énergie de la bande interdite (Eg), à partir des courbes de la figure 5A ;

la figure 6 est un graphique représentant un profil chimique obtenu par analyse de diffraction de rayons X (diffractométrie de rayons X), donnant la structure cristalline des échantillons, pour les échantillons observés aux figures 3 et 4 ;

la figure 7 est un graphique représentant des courbes courant-tension (J-V), sous illumination (AM1.5G) à 25°C, de cellules photovoltaïques tandem Si/Pk classiques à titre comparatif (A.1 et A.2) et de cellules photovoltaïques tandem Si/PK selon différents modes de réalisation particuliers de l'invention (A.3, A.4, A.5) ;

la figure 8 est une courbe obtenue par spectrométrie de masse ionique secondaire (SIMS) montrant le dopage d'une couche de pérovskite par du samarium, selon un autre mode de réalisation particulier.

Les différents éléments ne sont pas nécessairement représentés à une échelle uniforme pour rendre les figures plus lisibles.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 %, de préférence à 5 %.

Par transparent, on entend que la structure ou l'élément considéré a une transmittance supérieure ou égale à 70 %, de préférence supérieure ou égale à 80% et encore plus préférentiellement supérieure ou égale à 90%. La transmittance représente l'intensité lumineuse traversant l'élément ou la structure sur le spectre du visible. Elle peut être mesurée par spectrométrie UV-Vis-IR. La transmittance du spectre du visible correspond à la transmittance pour des longueurs d'ondes comprise entre 350 et 800 nm.

Par compris entre X et Y, on entend que les bornes X et Y sont incluses.

Le dispositif optoélectronique 100 peut être un dispositif choisi parmi :

- un dispositif photovoltaïque : une cellule solaire simple jonction, une cellule solaire en configuration tandem (Silicium / pérovskite, pérovskite / pérovskite, CIGS / pérovskite) ou, de manière plus générale, une cellule solaire multijonction (SI/PK/PK),
- un capteur de lumière comprenant en outre des pérovskites, quantum dots (par exemple PbS), II-VI (par exemple CdTe), CIGS, semiconducteurs couches minces, OLED, ou semiconducteurs organiques,
- un émetteur de lumière : pérovskites, quantum dots (par exemple PbS), II-VI (par exemple CdTe), CIGS, semiconducteurs couches minces, OLED, ou semiconducteurs organiques,
- un dispositif photocatalytique,
- un dispositif pour la photo-électrolyse.

De préférence, il s'agit d'une cellule photovoltaïque. La cellule photovoltaïque peut être de type n-i-p ou de type p-i-n (à structure inversée).

Le dispositif comprend au moins une couche active 140 en matériau pérovskite de formule générale $ABX_3$ avec :

A représentant un cation organique ou inorganique ou une combinaison de cations inorganiques et/ou de cations organiques,
B représentant du plomb (Pb), de l'étain (Sn), ou un de leurs mélanges,
X représentant un ou plusieurs anions, en particulier un ou
plusieurs halogènes, plus particulièrement choisis parmi le chlore, le brome, l'iode et un de leurs mélanges.

De préférence, les pérovskites sont des pérovskites hybrides organiques-inorganiques. Dans de tels matériaux pérovskites, A comprend un ou plusieurs cations organiques peuvent être associés à un ou plusieurs cations métalliques, par exemple du césium. Le ou les cations organiques peuvent être choisis parmi les cations alkyl-ammonium comme (par exemple un cation de type méthylammonium (MA)) et les cations formamidinium (FA).

Le matériau pérovskite est, de préférence, un composé de formule $(Cs,FA)(Sn,Pb)X_3$, encore plus préférentiellement $(Cs,FA)PbX_3$ avec X du chlore, du brome, de l'iode ou un de leur mélanges. On choisira de manière encore plus préférentielle $(Cs,FA)Pb(I,Br)_3$.

La couche active 140 comprend une première face et une deuxième face. La couche active 140 est dopée par du samarium sur une partie 141 de son épaisseur depuis la première face. Le dopage est réalisé à l'extrême surface de la couche active en pérovskite. La couche active n'est pas dopée sur toute son épaisseur : elle comprend une partie non dopée 142. Typiquement, l'épaisseur de la partie dopée 141 de la couche de pérovskite 140 est comprise entre 50 et 150 nm, de préférence entre 80 et 120 nm. Elle est, avantageusement, de l'ordre de 100 nm.

En substituant partiellement le plomb ou l'étain par le samarium en surface de la couche active 140 de la cellule solaire, une couche semiconductrice de pérovskite fortement dopée de type n est formée.

En effet, la pérovskite est un matériau semiconducteur qui a une forte tolérance aux défauts ponctuels et qui peut être dopée. Le samarium peut s'intégrer dans la matrice de la pérovskite en se substituant au plomb et/ou à l'étain, sans changer la phase cristalline de la pérovskite.

Le dopage d'une couche en pérovskite par un europium, et plus particulièrement par du samarium, est connu [1,2].

Ce dopage est particulièrement avantageux dans le cas d'une cellule photovoltaïque. En effet, la partie dopée 141 de la couche active en pérovskite 140 permet de séparer et d'extraire les charges négatives créées dans la couche active 140. Elle joue le rôle de couche conductrice de type n, ce qui permet de s'affranchir de l'utilisation d'une couche de transport d'électrons (ETL pour 'Electrons Transport Layer') classique, par exemple en C60.

On obtient ici une cellule photovoltaïque à architecture simplifiée et ayant une très bonne stabilité.

La première face de la couche active est en contact direct avec une couche tampon 150 (autrement dit, il n'y a pas de couches intermédiaires entre la couche active 140 et la couche tampon 150). La deuxième face est en contact avec la couche de transport de trous 130 (aussi appelée couche de type p ou HTL pour 'Hole transport layer').

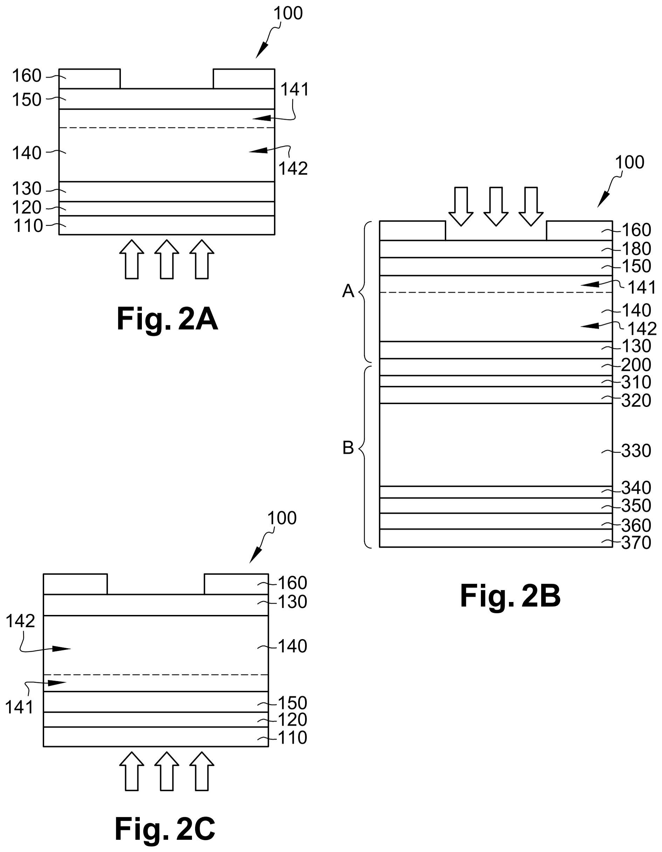

Par exemple, la cellule solaire 100 simple jonction p-i-n comprend successivement depuis la face soumise au rayonnement lumineux représenté par les flèches sur la figure 2A :

- un substrat 110, de préférence transparent, par exemple en verre,
- une première électrode 120 dite électrode inférieure, de préférence transparente, par exemple une couche en oxyde transparent conducteur (TCO pour 'Transparent conductive Oxide'),
- une couche conductrice de type p 130, par exemple en un carbazole,
- une couche active en pérovskite 140 ayant une partie dopée au samarium 141 et une partie non dopée 142,
- une couche tampon 150, de préférence, en BCP ou en oxyde métallique, en contact avec la partie dopée 141 de la couche active 140,
- une deuxième électrode 160 dite électrode supérieure en métal, par exemple en argent ou en aluminium.

Des contacts métalliques (non représentés), par exemple en Cr/Au, sont formés sur le substrat 110. Ils peuvent être déportés.

L'éclairement se fait à travers le substrat 110.

La première électrode 120 est, de préférence, en un TCO (oxydes conducteurs transparents) choisi parmi, par exemple, l'ITO (oxyde d'indium-étain ou 'Indium Tin Oxide'), l'AZO (oxyde d'aluminium-zinc), l'IZO (oxyde d'indium-zinc) ou en un oxyde choisi parmi ZnO ou Al :ZnO. Dans le cas d'un TCO, elle peut avoir une épaisseur comprise entre 50 et 500 nm et dans le cas d'un oxyde, elle peut avoir une épaisseur comprise entre 20 et 250 nm.

Le matériau de type p peut aussi être choisi, par exemple, parmi les poly(styrène sulfonate) de sodium (PSS), les oxydes tels que $WO_3$, $MoO_x$ (par exemple $MoO_3$), $V_2O_5$, $NiO_x$ (par exemple NiO), $NiO_x$ : Cu, ou encore parmi les polymères pi-conjugués (tels que le poly(3,4-éthylènedioxythiophène) (PEDOT), les poly(3-hexylthiophène) ou P3HT et les PTAA), ou un de leurs mélanges leurs mélanges. Il peut également s'agit d'une monocouche de molécules autoassemblée (ou SAM pour 'Self Assembled Monolayer') par exemple en un carbazole, notamment choisi parmi l'un des composants suivants : 2PACz (acide (2-(9H-carbazol-9-yl)éthyl)phosphonique)), 3PACz, 4PACz, Me-4PACz, MeO-2PACz, MPA ou d'un dérivé ayant une fonction d'ancrage sur oxides. L'épaisseur de la couche p 130 est comprise entre 1 et 50 nm, l'épaisseur étant choisie en fonction de la nature de la couche. Par exemple, pour les SAM, l'épaisseur de la couche 130 est, de préférence, comprise entre 1 et 5 nm alors que pour des polymères pi-conjugués, elle peut être comprise entre 5 et 50 nm.

La couche active en pérovskite 140 a, par exemple, une épaisseur comprise entre 200 nm et 1,5 $\mu$m.

La couche tampon 150 est dépourvue de samarium. La couche tampon 150 peut être une couche de BCP ou une couche d'oxyde métallique, par exemple choisi parmi $SnO_x$ (avec x compris entre 1 et 2), $SnO_xN_y$, $TiO_x$, $ZnO_x$. De préférence, la couche tampon 150 est en $SnO_x$, $SnO_xN_y$ ou BCP. De préférence, elle est en oxyde métallique. Elle a, par exemple, une épaisseur comprise entre 1 et 7 nm pour le BCP et entre 5 et 50 nm lorsqu'il s'agit d'une couche d'oxyde.

La couche tampon 150 sert à :

- éliminer l'accumulation des charges entre l'électrode supérieure 160 et le matériau de type n (comme la pérovskite dopée n),
- faciliter l'extraction des porteurs et diminuer ainsi la recombinaison des charges (trous-électrons) à l'interface couche n/électrode supérieure 160,
- protéger le matériau de type n lors du dépôt de l'électrode supérieure 160,
- empêcher la diffusion des halogènes vers l'électrode supérieure 160 en améliorant ainsi la durée de vie de la cellule solaire.

L'électrode supérieure 160 est, par exemple, métallique. Elle peut être en Ag, Cu, Ni, Al. Elle a, par exemple, une épaisseur comprise entre 50 et 500 nm.

La cellule solaire 100 peut être une cellule tandem silicium pérovskite de type p-i-n. Il s'agit d'une structure comprenant deux sous-cellules A, B empilées l'une sur l'autre. La sous-cellule supérieure A est une sous-cellule en pérovskite tandis que la sous-cellule inférieure B est en silicium, notamment il s'agit d'une sous-cellule à hétérojonction de silicium (figure 2B).

Les deux sous-cellules A, B peuvent être séparées par une couche intermédiaire 200 électroniquement conductrice ou semi-conductrice, et de préférence, transparente au rayonnement électromagnétique. Elle peut être en un TCO (oxydes conducteurs transparents) choisis parmi, par exemple, l'ITO (oxyde d'indium-étain), l'AZO (oxyde d'aluminium-zinc), l'IZO (oxyde d'indium-zinc). Elle a, par exemple, une épaisseur comprise entre 5 et 100 nm.

La sous-cellule A à base de pérovskite comprend successivement depuis la face supérieure face exposée au rayonnement lumineux représenté par des flèches sur la figure 2B :

- une électrode dite électrode supérieure 160 de préférence transparente,
- une couche tampon 150, de préférence en BCP ou en oxyde métallique, par exemple en $SnO_xN_y$, en contact avec la partie dopée 141 de la couche active 140,
- une couche active en pérovskite 140 dont une partie 141 est dopée au samarium et joue le rôle d'ETL,
- une couche conductrice de type p 130 (HTL).

La sous-cellule B à hétérojonction de silicium comprend, par exemple, depuis la couche intermédiaire 200 ou depuis la sous-cellule à base de pérovskite :

- une couche en silicium amorphe dopé n 310,
- de préférence une couche à base de silicium amorphe intrinsèque 320 servant de couche en passivation,
- un substrat en silicium cristallin dopé n 330,
- de préférence, une couche à base de silicium amorphe intrinsèque 340 servant de couche en passivation,
- une couche en silicium amorphe dopé p 350,
- une électrode 360, de préférence transparente.

Des contacts métalliques 370, par exemple en argent, sont formés sur l'électrode 360 de la sous-cellule à base de silicium et d'autres contacts métalliques peuvent être formés sur l'électrode supérieure 160 de la sous-cellule à base de pérovskite. Ils peuvent être déportés au niveau de la face éclairée.

L'éclairement d'un dispositif tandem Si/PK 100 est réalisé à partir de la sous-cellule à base de pérovskite.

Les matériaux et épaisseurs précédemment décrits pour la cellule pérovskite simple jonction peuvent être utilisés pour la sous-cellule à base de pérovskite.

Les cellules solaires 100 pourraient également être des cellules de type n-i-p à simple jonction ou des cellules tandem de type n-i-p.

La figure 2C représente, par exemple, une cellule 100 de type n-i-p à simple jonction. La cellule comprend depuis la face supérieure face exposée au rayonnement lumineux représenté par des flèches :

- un substrat 110,
- une première électrode 120 dite électrode inférieure,
- une couche tampon 150 en contact direct avec la première face de la couche active en pérovskite,
- la couche active en pérovskite 140, dont une partie 141 de son épaisseur est dopée au samarium, depuis la première face,
- une couche conductrice de type p 130,
- une deuxième électrode 160 dite électrode supérieure.

Les matériaux et épaisseurs précédemment décrits pour la cellule pérovskite simple jonction ou pour la sous-cellule à base de pérovskite peuvent être utilisés pour les cellules de type n-i-p.

Les dispositifs 100 décrits présentent de bonnes propriétés (stabilité, rendement) tout en étant plus facile à fabriquer.

Le procédé de fabrication de telles cellules comprend une étape au cours laquelle une partie 141 de la couche active en pérovskite 140 est dopée avec du samarium. Le dopage est réalisé depuis la première face de la couche active 140. A l'issue de l'étape de dopage, la couche active 140 comprend une partie dopée 141 jouant le rôle d'ETL et une partie non dopée 142 jouant le rôle de couche active.

Il n'est ainsi plus nécessaire de déposer une couche de type n (par exemple en C60), sur la couche de pérovskite des cellules solaires p-i-n en simple jonction ou en tandem. La procédure de fabrication des cellules solaires est facilitée car le nombre de couches à déposer est réduit.

Dans le cas d'une structure de type p-i-n, le procédé de fabrication de la cellule peut comprendre les étapes suivantes :

- déposer une couche active de pérovskite 140,
- doper la couche de pérovskite 140, depuis une première face de la couche active 140, de manière à former une partie dopée 141 et une partie non dopée 142,

- déposer la couche tampon 150 sur la partie dopée 141 de la couche active 140.

Le dopage peut être facilement réalisé en déposant une solution contenant du samarium et un solvant sur la couche active 140 en pérovskite.

Le samarium est, par exemple, de l'iodure de samarium ($SmI_2$) ou de l'acétylacétonate de samarium ($Sm(acac)_3$).

De préférence, la concentration en $SmI_2$ est inférieure ou égale à 2mg/mL. Elle peut être comprise entre 0,5 mg/mL et 2 mg/mL.

De préférence, le solvant est de l'isopropanol (IPA). Un tel solvant ne détériore pas les couches de la cellule photovoltaïque déjà formées, par rapport à d'autres solvants comme le N, N-diméthylformamide (DMF).

La solution contenant le samarium peut être déposée par voie solvant (voie chimique liquide), par exemple avec une méthode de type dépôt à la tournette aussi appelée enduction centrifuge ('spin-coating'), enduction par trempage ('dipping'), impression ('printing'), dépôt par fente ('slot-die coating'), étalement au couteau ou dépôt par raclage ('doctor-blading'), impression par jet d'encre ('inkjet-printing'), pyrolyse par pulvérisation ('spray-pyrolysis'), sol-gel et dépôt par bain chimique. Ces méthodes de dépôt par voie liquide sont faciles et rapides à mettre en œuvre, tout en présentant un faible coût d'élaboration.

Le dépôt est, de préférence, réalisé par dépôt à la tournette ('spin coating').

De préférence, le dépôt à la tournette est réalisé en mode dynamique. Le mode dynamique permet d'introduire le Sm uniquement en surface de la couche de pérovskite 140.

Par mode dynamique, on entend que lorsque la solution est déposée à la surface de la couche de pérovskite 140, la couche de pérovskite 140 est déjà en rotation. Le mode dynamique se différencie du mode statique dans lequel la couche de pérovskite est mise en rotation après avoir déposé la solution à sa surface.

Par exemple, le dépôt en mode dynamique comprend les étapes suivantes :

- positionner la structure contenant la couche de pérovskite 140 sur un plateau dans une machine de dépôt à la tournette, la structure pouvant être maintenue sur le plateau par aspiration,
- mettre en rotation le plateau, par exemple à 3000 tours/min, et maintenir la rotation,
- déposer la solution contenant le samarium à la surface de la couche de pérovskite 140, le plateau étant toujours en rotation,
- maintenir la rotation après le dépôt de la solution, par exemple pendant une durée de 30s,
- arrêter la rotation du plateau.

Dans le cas d'une cellule de type p-i-n, le procédé de fabrication de la cellule comprend, par exemple, les étapes suivantes :

- formation de la partie dopée 141 de la couche de pérovskite 140 en déposant une couche fine à base de pérovskite à partir d'une solution qui contient les éléments : Cs, FA, Pb, Sm, I, Br (le Sm peut être introduit dans la solution, par exemple, sous forme de $SmI_2$ ou $Sm(acac)_3$),
- formation de la partie non dopée 142 de la couche de pérovskite 140 en déposant une couche de pérovskite à partir d'une solution standard (i.e. qui ne contient pas de Sm), par exemple, avec une solution qui contient les éléments : Cs, FA, Pb, I, Br.

Les différentes couches des cellules photovoltaïques 100 peuvent être déposées par des techniques classiquement utilisées.

Les électrodes supérieures 160 peuvent être déposées par sérigraphie, évaporation thermique ou faisceau d'électrons ('electron beam').

Les électrodes transparentes 120 peuvent être déposées par dépôt de couches atomiques (ALD pour 'Atomic Layer Deposition') ou pulvérisation cathodique.

La couche tampon 150 peut être déposée par évaporation thermique dans le cas du BCP ou par enduction centrifuge ('spin coating'), revêtement par filière à fente ('slot die'), dépôt par raclage ('Doctor Blade'), ALD ou pulvérisation cathodique dans le cas d'un oxyde.

La couche en pérovskite 140 peut être déposée, par exemple, par l'une des techniques suivantes données à titre illustratif et non limitatif : évaporation ou co-évaporation thermique (PVD), sublimation en espace fermé ('Close space sublimation' ou CSS), dépôt chimique en phase vapeur (CVD) ou ALD, ablation laser pulsé ('Pulsed Laser deposition' ou PLD). Il peut également s'agir d'une technique de dépôt dite hybride combinant par exemple un dépôt par voie liquide (enduction centrifuge, dépôt par raclage, ou filière à fente, par exemple) et une autre technique de dépôt choisie parmi CSS, PVD, PLD, CVD ou ALD.

La couche de type p 130 peut être déposée par enduction centrifuge, dépôt par raclage, filière à fente, évaporation thermique, ALD, pulvérisation cathodique.

La couche intermédiaire 200 peut être déposée par pulvérisation cathodique ou ALD.

Exemples illustratifs et non limitatifs

Dans un premier temps, des échantillons avec des couches de pérovskite ont été préparés et caractérisés. Un des échantillons n'a pas reçu de traitement de surface et les deux autres échantillons ont reçu un traitement de surface pour doper la pérovskite avec une composition de $SmI_2$ à différentes concentrations.

Les échantillons comprennent, depuis un substrat un verre, une couche d'oxyde transparent conducteur, une couche de type p (2PACz) et une couche de pérovskite de formule $(Cs, FA)Pb(I,Br)_3$.

Les échantillons ont été préparés de la façon suivante :

- déposer, sur un substrat en verre recouvert d'une couche d'oxyde transparent conducteur (TCO), une couche de PACz par dépôt à la tournette ('spin-coating'), de préférence sous $N_2$, et réaliser un traitement thermique pendant 10 min à 100°C,
- déposer la couche de pérovskite par dépôt à la tournette, de préférence, sous $N_2$ et réaliser un traitement thermique pendant 60 min à 100°C.

Pour le premier échantillon (échantillon B1), aucun traitement de surface n'a été mis en œuvre sur la couche de pérovskite.

Pour les deux autres échantillons, une solution de $SmI_2$ a été déposée sur la couche de pérovksite. La concentration utilisée pour l'échantillon B2 est de 2mg/mL et la concentration utilisée pour l'échantillon B3 est de 10mg/mL.

Les solutions de $SmI_2$ sont préparées en ajoutant une poudre de $SmI_2$ dans de l'IPA anhydre. Les solutions sont agitées à température ambiante (typiquement entre 20 et 25°C) pendant une durée, par exemple de 8 à 12h.

Les solutions sont déposées par dépôt à la tournette en mode dynamique. Pour cela, l'étape de dopage est réalisée selon les sous-étapes suivantes :

- positionner l'échantillon sur un plateau dans une machine de dépôt à la tournette,
- mettre en rotation le plateau, par exemple à 3000 tours/min,
- déposer 200 μl de la solution de $SmI_2$ dilué dans l'IPA à la surface de la couche de pérovskite, le plateau étant toujours en rotation,
- maintenir la rotation 30s après le dépôt de la solution,
- arrêter la rotation du plateau.

Un recuit de l'échantillon à 100°C pendant 10 minutes peut ensuite être réalisé.

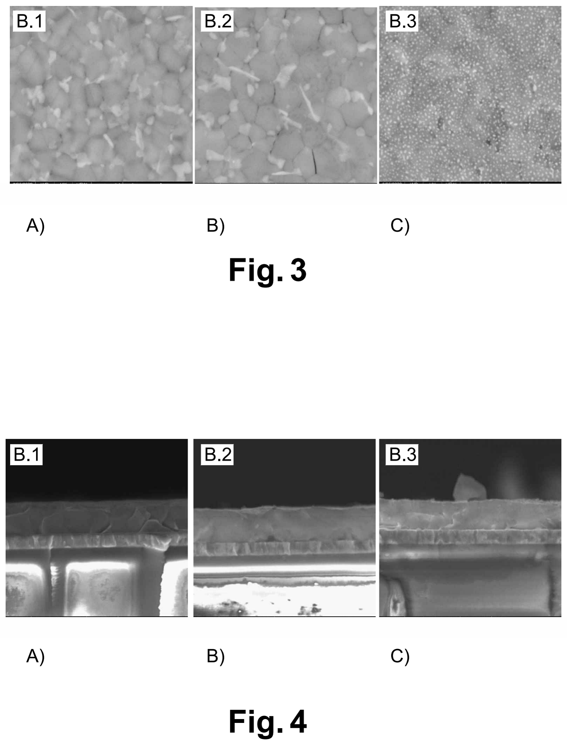

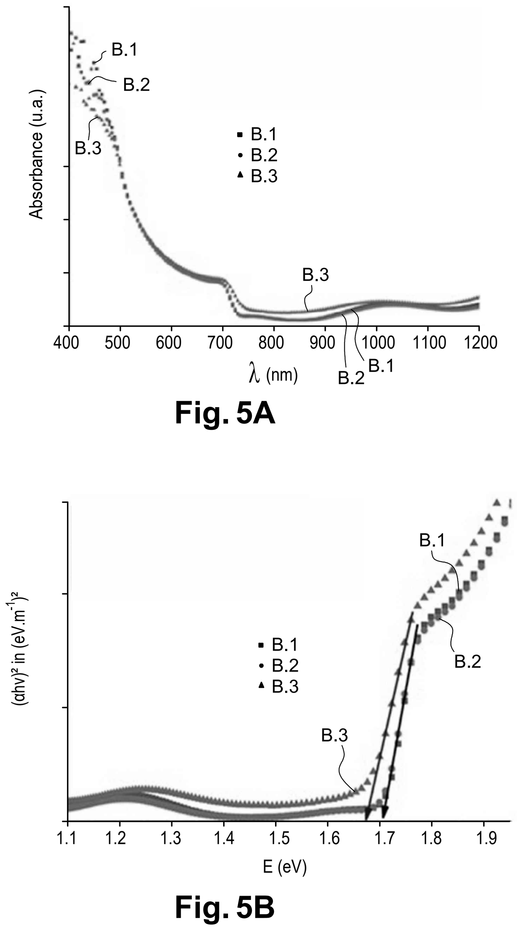

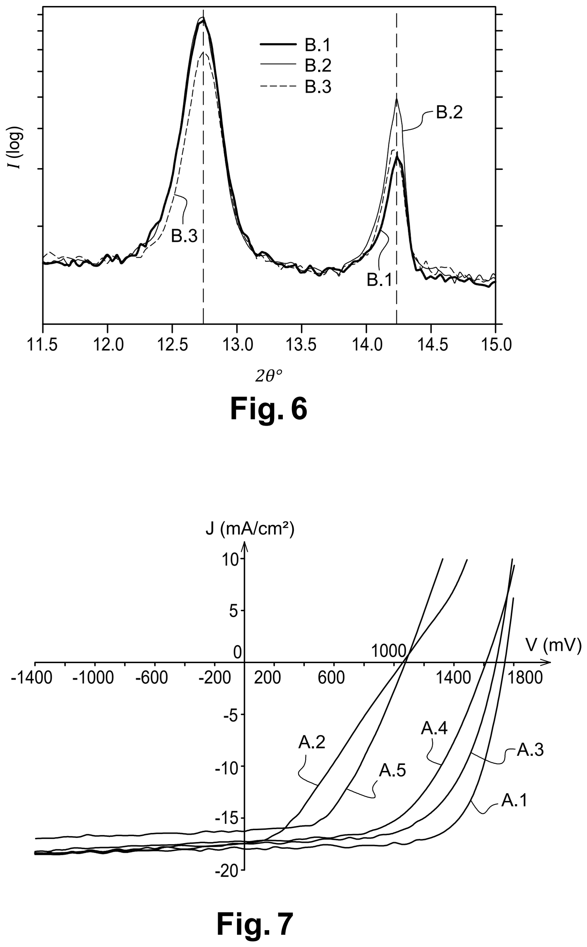

Les 3 échantillons ont été caractérisés par MEB (figures 3 et 4), UV-vis (figures 5A et 5B) et DRX (figure 6).

Les caractérisations MEB permettent de montrer que le traitement de surface avec la solution à 2 mg/ml (échantillon B2) n'impacte pas la morphologie ni la taille des grains de pérovskite. La caractérisation par DRX montre que les pics DRX de B1 et B2 sont identiques (même position et même largeur à mi-hauteur (' full width at half maximum' ou FWHM). Les pérovskites ont la même structure. Finalement, l'énergie de bande interdite mesurée est similaire pour B1 et B2.

Ces résultats indiquent que le dopage par le samarium (avec la solution de 2mg/ml) n'impacte pas les propriétés structurales et optiques de la pérovskite. Ceci laisse supposer que le dopage a bien conduit à la formation en surface d'une couche de pérovskite $(Cs,FA)(Pb,Sm)(I,Br)_3$ par substitution du plomb par le samarium. Cela peut laisser aussi supposer que le volume ('bulk') de la couche active 140 (i.e. la partie non dopée 142 sous la partie dopée 141) reste intact.

En revanche, le traitement de surface avec la solution à 10 mg/ml (échantillon B3) impacte la morphologie de la surface de la couche de pérovskite (taille des grains) : la surface de la couche est composée de petits grains à base de samarium. En revanche, la taille et la morphologie de grains de la pérovskite dans le volume sont peu impactés. Les pics de DRX sont décalés à gauche, ce qui indique une augmentation du paramètre de maille (« lattice expansion »). L'énergie de la bande interdite de la pérovskite de B3 est supérieure aux énergies de bande interdite des pérovskites B1 et B2. Cela laisse supposer que, au-delà d'une certaine concentration, en plus d'avoir substitué des atomes de plomb par du samarium, les atomes de samarium s'insèrent dans la maille, ce qui modifie les propriétés optiques de la pérovskite.

Des cellules photovoltaïques tandem silicium/pérovskite ont également été étudiées. Chacune de ces cellules comprend une sous-cellule en silicium. Une couche d'oxyde transparent conducteur (TCO) sépare la sous-cellule en silicium de la sous-cellule en pérovskite. La sous-cellule en silicium et la couche de TCO sont identiques pour chaque cellule tandem étudiée. Seule la sous-cellule en pérovskite est différente d'un échantillon à l'autre.

Le Tableau 1 ci-dessous répertorie les différentes sous-cellules en pérovskite utilisées.

[Table 1]

| N° | Architecture sous-cellule PK | Concentration en SmI$_2$ dans la solution |
|---|---|---|
| A.1 | 2PACz / PK / Couche n / BCP/ITO/ Ag | |
| A.2 | 2PACz/ PK/ BCP/ ITO / Ag | |
| A.3 | 2PACz / PK avec Sm / BCP/ ITO / Ag | 0,5mg/mL |
| A.4 | 2PACz / PK avec Sm / BCP/ ITO / Ag | 1mg/mL |
| A.5 | 2PACz / PK avec Sm / BCP/ ITO / Ag | 2mg/mL |

Pour ces différents essais, la couche HTL est une couche de 2PACz, la couche de pérovskite (PK) est une couche de (Cs,FA)Pb(I,Br)$_3$, la couche de TCO est une couche d'oxyde d'indium étain (ITO pour 'Indium Tin Oxide') et l'électrode est en argent.

La couche tampon est une couche de BCP (bathocuproine) sauf pour l'échantillon A.2 qui n'en contient pas.

La couche d'ETL (couche n) de l'exemple comparatif A.1 est une couche de C60. Dans les cas A.2, A.3, A.4 et A.5 il n'y pas la couche d'ETL.

Dans les cas A.3, A.4 et A.5, un traitement de surface avec une solution de SmI$_2$ a été réalisé sur la couche de pérovskite pour la doper en surface.

Les autres couches sont identiques pour les 5 échantillons.

Les cellules tandem ont été fabriquées selon les étapes suivantes :

- fournir des substrats ('wafer') en silicium polis double face de type n, de taille 6 pouces (soit 15,24 cm),
- déposer par PECVD des couches de a-Si :H de part et d'autre du substrat en silicium,
- déposer l'ITO en arrière et l'ITO de recombinaison en face avant par PVD,
- découper le substrat en Silicium par laser à des tailles de substrats de 2.5 x 2.5 cm$^2$,
- déposer l'électrode d'Ag en face arrière par évaporation thermique sous vide (1.10$^{-6}$ mbar) avec une vitesse de dépôt de 5 Å/s,
- déposer le 2PACz par dépôt à la tournette sous N$_2$,
- déposer la couche de pérovskite (Cs,FA)Pb(I,Br)$_3$ par dépôt à la tournette sous N$_2$, puis réaliser un traitement thermique pendant 1 heure sous azote à 100°C,
- pour l'échantillon A.1, déposer le C60 par évaporation thermique sous vide (1.10$^{-6}$ mbar) avec une vitesse de dépôt de 0.1 à 0.3 Å/s,
- déposer le BCP par évaporation thermique sous vide (1.10$^{-6}$ mbar) avec une vitesse de dépôt de 0.1 à 0.4 Å/s,
- déposer l'ITO en face avant par pulvérisation cathodique ('DC-sputtering') à 2500W,
- déposer l'électrode supérieure d'Ag par évaporation thermique sous vide (1.10$^{-6}$ mbar) avec une vitesse de dépôt de 5 Å/s.

Afin d'avoir une couche de pérovskite dont la surface est fortement dopée type n, pour les échantillons A.3, A.4 et A.5, des solutions de 200µL de SmI$_2$ sont déposées à la surface de la pérovskite par dépôt à la tournette (3000 tr/min pendant 30 s). Un recuit des échantillons à 100°C pendant 10 minutes est ensuite réalisé. Après le traitement de surface, les couches de BCP, d'ITO et d'Ag sont déposées comme décrit précédemment.

Les différentes solutions ont été préparées, comme précédemment, en ajoutant une poudre de SmI$_2$ dans de l'IPA anhydre. Après agitation à température ambiante (20-25°C) pendant 8 à 12h, les solutions sont prêtes.

La densité du courant en fonction de la tension a été mesurée pour chaque cellule tandem (figure 7).

Le Tableau 2 suivant répertorie les propriétés photovoltaïques des cellules solaires tandem Si/PK.

[Table 2]

| N° | $V_{oc}^{tandem}$ mV | Jsc mA/cm$^2$ | FF % | PCE% |
|---|---|---|---|---|
| A.1 | 1737 | 17.1 | 70.1 | 21.9 |
| A.2 | 1031 | 18.0 | 45.3 | 8.9 |
| A.3 | 1680 | 17.5 | 61.4 | 18.0 |
| A.4 | 1611 | 17.2 | 56.0 | 15.6 |
| A.5 | 1067 | 17.2 | 51.0 | 8.4 |

Ces différents résultats montrent que les cellules tandem (A.3 et A.4) sans C60 et avec une couche active en PK ayant été dopée en surface avec une solution de $SmI_2$ de 0.5mg/ml et 1mg/ml sont fonctionnelles avec des rendements photovoltaïques proches à ceux de la cellule de référence (A.1).

La configuration A.2 (Cellule standard sans C60) conduit de très faibles Voc, FF et donc PCE indiquant de problèmes d'extraction des porteurs et de recombinaisons de charges.

La cellule tandem (A.5) avec une couche active en PK ayant été dopée en surface avec une solution de $SmI_2$ de 2mg/ml a un faible Voc et un faible PCE.

Les cellules des configuration A.2 (Cellule standard sans C60) et A.5 (configuration avec $SmI_2$ 2mg/ml) ont de très faibles Voc autour de 1000mV, ce qui indique la présence de fortes recombinaisons de charges à l'interface PK/BCP.

Dans le cas A.2 (Cellule standard sans C60), le faible FF montre aussi une forte barrière d'extraction des porteurs de charges à l'interface PK/BCP.

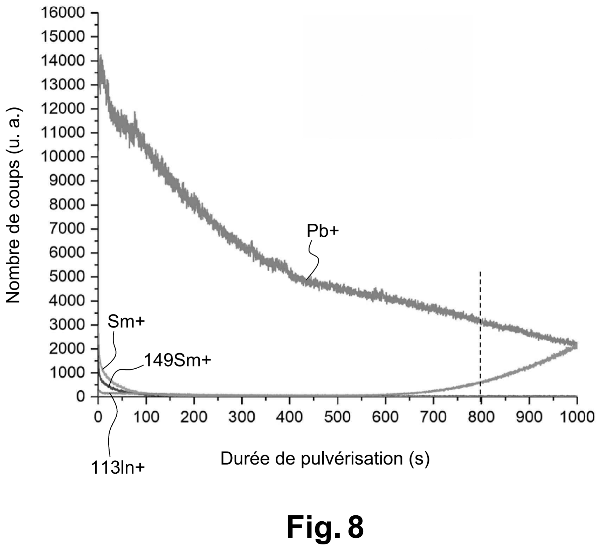

Dans un autre exemple, une analyse SIMS a été réalisée sur une couche de pérovskite dont une partie a été dopée au samarium par dépôt à la tournette d'une solution de $SmI_2$. La couche de pérovskite a une épaisseur de 575 nm. Sur la figure 8, le zéro correspond à la surface supérieure de la pérovskite (celle sur laquelle a été déposé la solution de samarium) et les traits pointillés correspondent à l'interface pérovskite/ITO. L'analyse montre que le dopage en Sm se passe en surface de la couche de pérovskite et qu'il ne pénètre pas dans toute la couche (figure 8). La région de dopage est estimée à une épaisseur d'environ 92-95 nm.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

REFERENCES

[1] Molenda et al. "Redox-active ions unlock substitutional doping in halide perovskites" Mater. Horiz., 2023, 10, 2845-2853

[2] Chih Shan Tan "Lead-free europium and ytterbium perovskites", RSC Adv., 2023, 13, 19013-19019

**Revendications**

1. Dispositif optoélectronique (100) comprenant une couche active en pérovskite (140), la couche active en pérovskite (140) étant dopée au samarium, depuis une première face de la couche active en pérovskite (140), sur une partie (141) de son épaisseur, une couche tampon (150), par exemple en BPC ou en oxyde, étant en contact direct avec la première face de la couche active en pérovskite (140),

   une couche conductrice de type p (130) étant en contact avec une deuxième face de la couche active en pérovskite (140),
   la pérovskite ayant pour formule $ABX_3$ avec A représentant un cation organique ou inorganique ou une combinaison d'un ou plusieurs cations organiques et/ou d'un ou plusieurs cations inorganiques, de préférence choisis parmi le méthylammonium, le formamidinium et le césium,
   B représentant du plomb, de l'étain ou un de leurs mélanges, X représentant un ou plusieurs anions, en particulier un ou plusieurs halogènes, de préférence choisis parmi le chlore, le brome, l'iode et un de leurs mélanges.

2. Dispositif selon la revendication 1, dans lequel la pérovskite a pour formule $(Cs,FA)(Sn,Pb)(I,Br)_3$, de préférence $(Cs,FA)Pb(I,Br)_3$.

3. Dispositif selon l'une des revendications 1 et 2, la partie (141) dopée de la couche active en pérovskite (140) a une épaisseur comprise entre 50 et 150 nm, de préférence entre 80 et 120 nm.

4. Dispositif selon l'une des revendications 1 à 3, dans lequel le dispositif optoélectronique (100) est une cellule photovoltaïque à simple jonction de type p-i-n, comprenant, par exemple, depuis une face soumise à un rayonnement lumineux :

   - un substrat (110),

- une électrode inférieure (120),
- la couche conductrice de type p (130),
- la couche active en pérovskite (140) dopée au samarium, depuis la première face de la couche active en pérovskite (140), sur une partie (141) de son épaisseur,
- une couche tampon (150) en contact direct avec la première face de la couche active en pérovskite (140),
- une électrode supérieure (160).

5. Dispositif selon l'une des revendications 1 à 3, dans lequel le dispositif optoélectronique (100) est une cellule photovoltaïque tandem pérovskite sur silicium de type p-i-n comprenant deux sous-cellules empilées l'une sur l'autre, une première sous-cellule (A) étant une sous-cellule en pérovskite et une deuxième sous-cellule (B) étant une sous-cellule en silicium, par exemple une sous-cellule à hétérojonction de silicium, la première sous-cellule (A) comprenant, par exemple, depuis une face soumise à un rayonnement lumineux :

- une électrode supérieure (160),
- une couche d'oxyde transparent conducteur (180),
- une couche tampon (150) en contact direct avec la première face de la couche active en pérovskite (140),
- la couche active en pérovskite (140) dopée au samarium, depuis la première face de la couche active en pérovskite (140), sur une partie (141) de son épaisseur,
- la couche conductrice de type p (130).

6. Dispositif selon l'une des revendications 1 à 3, dans lequel le dispositif optoélectronique (100) est une cellule photovoltaïque à simple jonction de type n-i-p, comprenant, par exemple, depuis une face soumise à un rayonnement lumineux :

- un substrat (110),
- une électrode inférieure (120),
- une couche tampon (150) en contact direct avec la première face de la couche active en pérovskite,
- la couche active en pérovskite (140) dopée au samarium, depuis la première face de la couche active en pérovskite (140), sur une partie (141) de son épaisseur,
- la couche conductrice de type p (130),
- une électrode supérieure (160).

7. Dispositif selon l'une des revendications précédentes, dans lequel la couche conductrice de type p (130) est en un matériau choisi parmi les poly(styrène sulfonate) de sodium, les oxydes métalliques, les polymères pi-conjugués, les monocouches de molécules autoassemblées et/ou dans lequel l'épaisseur de la couche conductrice de type p (130) est comprise entre 1 et 50 nm.

8. Dispositif selon l'une des revendications précédentes, dans lequel la couche active en pérovskite (140) a une épaisseur comprise entre 20 nm et 1,5 $\mu$m.

9. Dispositif selon l'une des revendications précédentes, dans lequel la couche tampon (150) a une épaisseur comprise entre 1 nm et 50 nm.

10. Dispositif selon l'une des revendications précédentes, dans lequel le dopage au samarium est réalisé avec un cation de samarium de degré d'oxydation +2.

11. Procédé de fabrication d'un dispositif optoélectronique (100) comprenant une étape au cours de laquelle une couche active en pérovskite (140) est dopée au samarium depuis une première face de la couche active (140), sur une partie (141) de son épaisseur, moyennant quoi une couche de type n est formée dans la couche active en pérovskite (140),

la pérovskite ayant pour formule $ABX_3$ avec A représentant un cation organique ou inorganique ou une combinaison d'un ou plusieurs cations organiques et/ou d'un ou plusieurs cations inorganiques, de préférence choisis parmi le méthylammonium, le formamidinium et le césium,
B représentant du plomb, de l'étain ou un de leurs mélanges,
X représentant un ou plusieurs anions, en particulier un ou plusieurs halogènes, de préférence choisis parmi le chlore, le brome, l'iode et un de leurs mélanges,
une couche tampon (150), par exemple en BPC ou en oxyde, étant en contact direct avec la première face de la couche active en pérovskite (140),

la couche active en pérovskite (140) étant, de préférence, formée sur une couche conductrice de type p (130).

12. Procédé selon la revendication précédente, dans lequel le dopage au samarium est obtenu en déposant une solution contenant du samarium, par exemple $SmI_2$ ou $Sm(acac)_3$, sur la couche active en pérovskite (140).

13. Procédé selon la revendication 12, dans lequel la solution comprend du $SmI_2$ et de l'isopropanol.

14. Procédé selon l'une des revendications 12 et 13, dans lequel la solution est déposée par dépôt à la tournette en mode dynamique selon les sous-étapes suivantes :

- mettre en rotation la structure contenant la couche active en pérovskite (140) dans une machine de dépôt à la tournette, par exemple à 3000 tours/min,
- déposer la solution contenant du samarium, sur la couche active en pérovskite (140), la structure étant toujours en rotation,
- maintenir la rotation après le dépôt de la solution, par exemple pendant une durée de 30s,
- arrêter la rotation de la structure.

15. Procédé selon l'une des revendications 12 à 14, dans lequel la solution a une concentration en $SmI_2$ inférieure ou égale à 2mg/mL, de préférence comprise entre 0,5mg/mL et 2mg/mL.

16. Procédé selon l'une des revendications 11 à 15, dans lequel le dispositif optoélectronique (100) est une cellule photovoltaïque de type p-i-n, par exemple une cellule photovoltaïque tandem silicium sur pérovskite ou une cellule photovoltaïque à simple jonction.

**Fig. 1A**

(Art antérieur)

**Fig. 1B**

(Art antérieur)

**Fig. 1C**

(Art antérieur)

**Fig. 2A**

**Fig. 2B**

**Fig. 2C**

16

A)  B)  C)

# Fig. 3

A)  B)  C)

# Fig. 4

**Fig. 5A**

**Fig. 5B**

**Fig. 6**

**Fig. 7**

**Fig. 8**

Europäisches
Patentamt

European
Patent Office

Office européen
des brevets

**RAPPORT DE RECHERCHE EUROPEENNE**

Numéro de la demande

**EP 25 21 7588**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | MOLENDA ZUZANNA ET AL: "Electronic Doping in Perovskite Solar Cells", ADVANCED ELECTRONIC MATERIALS, vol. 10, no. 10, 1 octobre 2024 (2024-10-01), XP093296829, ISSN: 2199-160X, DOI: 10.1002/aelm.202400090 | 1,2,4, 7-16 | INV. H10K30/85 H10K30/40 H10K71/30 H10K85/50 ADD. |
| Y | * page 2 - page 6; figures 3d,4; tableau 1 * | 3 | H10K30/57 H10K71/12 |
| | ----- | | |
| X | YANG YANG ET AL: "Redox-inactive samarium(III) acetylacetonate as dopant enabling cation substitution and interfacial passivation for efficient and stable CsPbI2Br perovskite solar cells", APL MATERIALS, AMERICAN INSTITUTE OF PHYSICS, 2 HUNTINGTON QUADRANGLE, MELVILLE, NY 11747, vol. 8, no. 7, 2 juillet 2020 (2020-07-02), XP012248213, DOI: 10.1063/5.0011918 * page 2 - page 7; figures 2e,g,h, 3c,4a; tableau I * | 1,4 | |
| | ----- | | DOMAINES TECHNIQUES RECHERCHES (IPC) |
| | -/-- | | H10K |

Le présent rapport a été établi pour toutes les revendications

| Lieu de la recherche | Date d'achèvement de la recherche | Examinateur |
|---|---|---|
| La Haye | 20 mars 2026 | Tena Zaera, Ramon |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

page 1 de 3

RAPPORT DE RECHERCHE EUROPEENNE

Numéro de la demande

EP 25 21 7588

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | SUBHANI WAQAS SIDDIQUE ET AL: "Interface-Modification-Induced Gradient Energy Band for Highly Efficient CsPbIBr 2 Perovskite Solar Cells", ADVANCED ENERGY MATERIALS , vol. 9, no. 21 10 avril 2019 (2019-04-10), page 1803785, XP055969113, Weinheim ISSN: 1614-6832, DOI: 10.1002/aenm.201803785 Extrait de l'Internet: URL:https://onlinelibrary.wiley.com/doi/fu ll-xml/10.1002/aenm.201803785 * page 2 - page 6; figure 1d * & SUBHANI WAQAS SIDDIQUE ET AL: "Supporting information: Interface-Modification-Induced Gradient Energy Band for Highly Efficient CsPbIBr2 Perovskite Solar Cells", ADVANCED ENERGY MATERIALS, vol. 9, no. 21, 1 juin 2019 (2019-06-01), XP093296831, Weinheim ISSN: 1614-6832, DOI: 10.1002/aenm.201803785 ----- | 1,5,6 | |
| Y | MOLENDA ZUZANNA ET AL: "Redox-active ions unlock substitutional doping in halide perovskites", MATER. HORIZ., vol. 1, no. 8, 1 juillet 2023 (2023-07-01) , pages 2845-2853, XP093296832, ISSN: 2051-6347, DOI: 10.1039/d3mh00663h * page 2 - page 6; figure 1d * -/-- | 3 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| La Haye | 20 mars 2026 | Tena Zaera, Ramon |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..............................................................................
& : membre de la même famille, document correspondant

EPO FORM 1503 03.82 (P04C02)

Europäisches Patentamt

European Patent Office

Office européen des brevets

**RAPPORT DE RECHERCHE EUROPEENNE**

Numéro de la demande

EP 25 21 7588

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| | & Molenda: "Supporting Information: Redox-active ions unlock substitutional doping in halide perovskites", Materials Horizon, 6 juillet 2023 (2023-07-06), XP093296855, Extrait de l'Internet: URL:https://pubs.rsc.org/en/content/articlehtml/2023/mh/d3mh00663h * figure S4 * ----- | | |
| A | WO 2024/023437 A1 (UNIV BORDEAUX [FR]; INST POLYTECHNIQUE BORDEAUX [FR] ET AL.) 1 février 2024 (2024-02-01) * alinéas [0097] - [0103]; figures 4,5 * ----- | 1-16 | |
| A | WO 2022/192711 A1 (UNIV NORTH CAROLINA CHAPEL HILL [US]) 15 septembre 2022 (2022-09-15) * page 10 - page 16; revendications 1,21 * ----- | 1-16 | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| La Haye | 20 mars 2026 | Tena Zaera, Ramon |

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 25 21 7588

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-03-2026

| Document brevet cité au rapport de recherche | Date de publication | Membre(s) de la famille de brevet(s) | Date de publication |
|---|---|---|---|
| WO 2024023437 A1 | 01-02-2024 | EP 4562231 A1 | 04-06-2025 |
| | | FR 3138452 A1 | 02-02-2024 |
| | | WO 2024023437 A1 | 01-02-2024 |
| WO 2022192711 A1 | 15-09-2022 | AUCUN | |

EPO FORM P0460